# EUROPÄISCHE PATENTSCHRIFT

(11) **EP 4 460 917 B1**
(45) Veröffentlichungstag und Bekanntmachung des Hinweises auf die Patenterteilung: **02.09.2026**
(21) Anmeldenummer: 24709683.7
(22) Anmeldetag: 04.03.2024
(51) Int. Cl.: H04B 17/29, G01R 29/10, H04B 7/08

(54) **DIAGNOSEVERFAHREN FÜR EIN RUNDFUNK-EMPFANGSSYSTEM UND DAS RUNDFUNK-EMPFANGSSYSTEM**
DIAGNOSTIC METHOD FOR A RADIO RECEIVING SYSTEM, AND RADIO RECEIVING SYSTEM
PROCÉDÉ DE DIAGNOSTIC POUR UN SYSTÈME DE RÉCEPTION RADIO ET SYSTÈME DE RÉCEPTION RADIO

(30) Priorität: 20.03.2023 DE 102023001094
(43) Veröffentlichungstag der Anmeldung: 13.11.2024
(73) Patentinhaber: Mercedes-Benz Group AG, 70372 Stuttgart (DE)
(72) Erfinder: GAMMERT, Dominik, 75245 Neulingen (DE)
(74) Vertreter: Novagraaf Group
(86) Internationale Anmeldenummer: PCT/EP2024/055609
(87) Internationale Veröffentlichungsnummer: WO 2024/194000

(56) Entgegenhaltungen:
- US-A1- 2008 039 142
- US-A1- 2021 352 651
- US-B1- 10 361 798

## Beschreibung

Die Erfindung betrifft ein Diagnoseverfahren für ein Rundfunk-Empfangssystem eines Kraftfahrzeugs nach dem Oberbegriff des Anspruchs 1. Die Erfindung betrifft auch das Rundfunk-Empfangssystem und das Kraftfahrzeug mit dem Rundfunk-Empfangssystem. Aus EP 0 816 859 B1 ist bereits ein Rundfunk-Empfangssystem für ein Kraftfahrzeug mit zwei Empfänger und mit zwei Antennen bekannt. Die Empfänger und die Antennen definieren zwei Sende-Empfangspfade, so dass das Rundfunk-Empfangssystem in einem Phasen-Diversität-Modus betreibbar ist. Das Rundfunk-Empfangssystem weist zudem eine Steuerung zum Steuern der beiden Sende-Empfangspfade auf. Die Steuerung und die beiden Empfänger sind zu einem sogenannten Remote-Tuner-Modul zusammengefasst und die Antennen sind in einer Scheibe des Kraftfahrzeugs verbaut.

In EP 0 816 859 B1 ist auch ein Diagnoseverfahren für die Antennen des Rundfunk-Empfangssystem beschrieben. Dabei wird ein Testsignal mittels eines externen Signalgenerators erzeugt und von der jeweiligen Antenne empfangen. Anschließen wird das empfangene Testsignal ausgewertet, wobei die Signalstärke des Testsignals dabei Aufschluss über die Funktion der jeweiligen Antenne gibt.

Nachteiligerweise ist hier ein zusätzlicher Signalgenerator notwendig, der das Rundfunk-Empfangssystem und das Durchführen des Diagnoseverfahrens erschwert und verkompliziert.

DE 200 19 677 U1 offenbart ein Antennensystem mit mehreren Antennen, die in vorgegebenen Kombinationen über eine Kombinationseinheit an wenigstens zwei Empfänger anschließbar sind. Das Antennensystem weist zudem eine Signalverarbeitungseinheit zur Auswertung der Ausgangssignale der Empfänger und eine Steuereinheit zum Durchführen eines Selbsttests auf. Wenigstens eine der Antennen sendet bei dem mit einer über einen ersten Empfänger vorgegebene Prüffrequenz Prüfsignale, die in wenigstens eine weitere Antenne eingekoppelt sind. Zur Durchführung des Selbsttests werden die Empfangspegel des zweiten Empfängers als Istwerte erfasst und mit vorgegebenen Sollwerten verglichen.

DE 103 38 825 A1 offenbart eine Diagnoseeinrichtung sowie ein Diagnoseverfahren für ein Mehrantennensystem, mittels deren bzw. dessen ein Defekt einzelner Antennen des Mehrantennensystems erkannt werden kann. Dazu ist eine Einrichtung zur Erfassung der Länge der Einschaltzeit und/oder von Informationen über eine Signalstärke und Signalqualität jeder der Antennen des Mehrantennensystems ausgebildet. Aus diesen erfassten Daten werden durch eine Analyseeinrichtung ein Referenzwert ermittelt. Weiterhin ermittelt die Analyseeinrichtung mittels Vergleichs mit von vorgegebenen, vorabgespeicherten Referenzwerten im Fall, dass alle Antennen voll funktionsfähig sind, ein Defekt von einzelnen Antennen als vorliegend erkannt, wenn der Referenzwerte unter dem vorgegebenen Referenzwert liegt.

US 10 361 798 B1 offenbart ein System und ein Verfahren zur Leistungsmessung von Hochfrequenzkomponenten unter Verwendung von abgestrahlter Störenergie.

US 2008/039142 A1 offenbart eine W-CDMA-Basisstation mit einer Sonde und einem Prozessor, der in Verbindung mit einem Komparator den minimalen Empfangssignalpegel bestimmt.

US 2021/352651 A1 offenbart ein Verfahren zur Konfiguration von Ressourcen, um das Signal-zu-Interferenz-plus-Rausch-Verhältnis (SINR) zu bestimmen.

Die Aufgabe der Erfindung ist es daher, für ein Diagnoseverfahren der gattungsgemäßen Art eine verbesserte oder zumindest alternative Ausführungsform anzugeben, bei der die beschriebenen Nachteile überwunden werden. Die Aufgabe der Erfindung ist es auch, ein entsprechendes Rundfunk-Empfangssystem und ein Kraftfahrzeug mit dem Rundfunk-Empfangssystem bereitzustellen.

Diese Aufgabe wird erfindungsgemäß durch den Gegenstand des unabhängigen Anspruchs 1 gelöst. Vorteilhafte Ausführungsformen sind Gegenstand der abhängigen Ansprüche.

Die vorliegende Erfindung beruht auf dem allgemeinen Gedanken, zum Erzeugen eines Testsignals einen in dem Empfänger verbauten lokalen Oszillator zu verwenden und dadurch den Einsatz eines externen Signalgenerators zu vermeiden.

Das erfindungsgemäße Diagnoseverfahren ist für ein Rundfunk-Empfangssystem eines Kraftfahrzeugs ausgelegt. Das Rundfunk-Empfangssystem weist dabei einen ersten Sende-Empfangspfad und einen zweiten Sende-Empfangspfad auf. Der erste Sende-Empfangspfad ist durch einen ersten Empfänger und eine mit dem ersten Empfänger signalübertragend bzw. elektrisch verbundene erste Antenne und der zweite Sende-Empfangspfad ist durch einen zweiten Empfänger und eine mit dem zweiten Empfänger signalübertragend bzw. elektrisch verbundene zweite Antenne geformt. Die beiden Antennen sind dabei signalübertragend bzw. elektromagnetisch miteinander koppelbar. Zudem weist das Rundfunk-Empfangssystem eine Steuerung zum Steuern der beiden Sende-Empfangspfade auf. In dem Diagnoseverfahren wird erfindungsgemäß eine Diagnose durchgeführt. In dem ersten Sende-Empfangspfad wird dabei ein Testsignal mit einer vorgegebenen Testfrequenz über einen lokalen Oszillator des ersten Empfängers erzeugt und über die erste Antenne ausgesendet. In dem zweiten Sende-Empfangspfad wird das gesendete Testsignal über die zweite Antenne empfangen und über den zweiten Empfänger zu der Steuerung geleitet. Es versteht sich dabei, dass der zweite Empfänger zum Empfangen des Testsignals bei der vorgegebenen Testfrequenz eingestellt wird. Die Steuerung bewertet dann basierend auf dem empfangenen Testsignal die Funktionsfähigkeit der zweiten Antenne.

Im dem erfindungsgemäßen Diagnoseverfahren wird der lokale Oszillator des ersten Empfängers zum Erzeugen des Testsignals mit der vorgegebenen Testfrequenz verwendet. Dadurch ist kein externer Signalgenerator zum Durchführen des Diagnoseverfahrens notwendig und dadurch ist die Anzahl der Bauteile und der Aufwand bei der Diagnose der zweiten Antenne reduziert. Dadurch fallen auch weniger Kosten an und das Rundfunk-Empfangssystem ist durch weniger Bauteile auch zuverlässiger.

Das in dem ersten Sende-Empfangspfad erzeugte Testsignal kann innerhalb eines bestimmten Umkreis von weiteren Rundfunk-Empfangssystemen empfangbar und daher für die weiteren Rundfunk-Empfangssysteme störend sein. Um das zu vermeiden, kann das Diagnoseverfahren insbesondere in einer kontrollierten Umgebung durchgeführt werden.

Das Testsignal wird in dem erfindungsgemäßen Diagnoseverfahren mit dem lokalen Oszillator des ersten Empfängers erzeugt. Von einem lokalen Oszillator erzeugte Signale weisen üblicherweise eine hohe Güte und eine hohe Amplitudenstabilität auf und können als Testsignale besonders geeignet sein. Üblicherweise arbeiten die aktuellen Rundfunk-Empfangssysteme bei einer Zwischenfrequenz im Bereich einiger hundert kHz und die jeweiligen Empfänger sind als sogenannte Low-IF-Receiver bzw. Low-IF-Empfänger (Low-IF: Low-Intermediate-Frequency bzw. Nieder-Zwischenfrequenz) aufgebaut. Hier kann der lokale Oszillator den genannten Frequenzbereich größtenteils abdecken und zum Erzeugen der Mischfrequenz für das Testsignal verwendet werden.

Der erste Empfänger kann neben dem lokalen Oszillator auch weitere Bauelemente aufweisen. So kann der erste Empfänger neben dem lokalen Oszillator wenigstens einen Bandpassfilter und/oder wenigstens einen Mischer und/oder wenigstens einen Analog-Digital-Umsetzer und/oder wenigstens einen digitalen Signalprozessor aufweisen. Es versteht sich, dass der erste Empfänger und der zweite Empfänger zueinander identisch aufgebaut sein können. Insbesondere kann der zweite Empfänger gleiche Bauelemente aufweisen.

Die erste Antenne und die zweite Antenne sind signalübertragend bzw. elektromagnetisch miteinander koppelbar und können dazu in einem geeigneten Abstand und in einer geeigneten Position zueinander angeordnet bzw. ausgerichtet sein. Die erste Antenne und die zweite Antenne können Scheibenantennen sein bzw. durch Antennenstrukturen für Scheiben des Kraftfahrzeugs abgebildet sein, wie unten näher beschrieben wird.

Die Steuerung kann die beiden Sende-Empfangspfade steuern und das empfangene Testsignal auswerten bzw. die Funktionalität der zweiten Antenne anhand des empfangenen Testsignals bewerten. Die Steuerung kann beispielweise durch einen Mikrokontroller abgebildet sein. Die beiden Empfänger und die Steuerung können in einer gemeinsamen Baueinheit - einem sogenannten Tuner-IC (IC: Integrated Circuit bzw. integrierter Schaltkreis) bzw. einem sogenannten Remote-Tuner-Modul - verbaut bzw. integriert sein. Die beiden Empfänger und die Steuerung können insbesondere antennennah - also insbesondere in demselben Kraftfahrzeug - verbaut sein.

Die beiden Sende-Empfangspfade sind vollwertig und voneinander unabhängig. Das Rundfunk-Empfangssystem kann dadurch in einem Phasen-Diversität-Modus betrieben werden. In dem Phasen-Diversität-Modus wird dabei der Sende-Empfangspfad mit kleineren Störungen verwendet. Es versteht sich, dass das Rundfunk-Empfangssystem in dem Phasen-Diversität-Modus nur außerhalb des Diagnoseverfahrens betrieben wird.

Das empfangene Testsignal kann nach dem Empfangen durch den zweiten Empfänger in der Steuerung bearbeitet und abgespeichert werden. Dabei kann insbesondere die Amplitude bzw. die Feldstärke des empfangenen Testsignals bei der vorgegebenen Testfrequenz abgespeichert und zum Bewerten der Funktionsfähigkeit der zweiten Antenne genutzt werden. Das Bewerten der Funktionsfähigkeit der zweiten Antenne durch die Steuerung wird im Folgenden näher beschrieben.

Bei der Diagnose kann das Testsignal von dem lokalen Oszillator des ersten Empfängers zu der ersten Antenne über einen Umleitungspfad mit einem Schalter geleitet werden. Der Schalter des Umleitungspfads kann dabei beim Durchführen der Diagnose geschlossen und sonst geöffnet sein. Der Schalter kann insbesondere ein HF-Umschalter (HF: High Frequency bzw. Hochfrequenz) sein. Über den Umleitungspfad und den geschlossenen Schalter kann das Testsignal von dem lokalen Oszillator des ersten Empfängers zu der ersten Antenne geleitet werden und dort ausgesendet werden. Der Schalter ist dabei ausschließlich bei der Diagnose geschlossen, so dass Signale des lokalen Oszillators des ersten Empfängers außerhalb der Diagnose den Betrieb des Rundfunk-Empfängersystems nicht negativ beeinträchtigen können. Mit anderen Worten bleibt die erste Antenne außerhalb der Diagnose von dem lokalen Oszillator des ersten Empfängers entkoppelt und Störungen zwischen den beiden Empfängern können verhindert werden.

In dem Diagnoseverfahren wird erfindungsgemäß vor der Diagnose eine Referenzmessung durchgeführt. Da es nicht ausgeschlossen sein kann, dass die zweite Antenne während des Diagnoseverfahrens weitere externe Signale empfängt, können diese weitere externe Signale in der Referenzmessung erfasst und bei der Bewertung der Funktionsfähigkeit der zweiten Antenne berücksichtigt werden. Mit anderen Worten kann eine Nullmessung durchgeführt werden, die anschließend beim Bewerten der Funktionsfähigkeit der zweiten Antenne berücksichtigt werden kann. Bei der Referenzmessung wird dabei der erste Empfänger in dem ersten Sende-Empfangspfad ausgeschaltet. In dem zweiten Sende-Empfangspfad wird dann ein Umgebungssignal bei der vorgegebenen Testfrequenz über die zweite Antenne empfangen und über den zweiten Empfänger zu der Steuerung geleitet. Es versteht sich, dass das jeweilige Testsignal und das jeweilige Umgebungssignal dieselbe Testfrequenz aufweisen. Die Steuerung speichert dann das empfangene Umgebungssignal zur Bewertung der Funktionsfähigkeit der zweiten Antenne ab. Dabei kann insbesondere die Amplitude bzw. die Feldstärke des empfangenen Umgebungssignals bei der vorgegebenen Testfrequenz gemessen und abgespeichert werden.

Die Steuerung kann dann das empfangene Testsignal und das empfangene Umgebungssignal bei der jeweiligen vorgegebenen Testfrequenz vergleichen. Dabei kann die Steuerung, sobald bei der jeweiligen vorgegebenen Testfrequenz das Testsignal um einen vordefinierten Referenzwert stärker als das Umgebungssignal ist, die zweite Antenne als funktionsfähig und sonst als nicht funktionsfähig bewerten. Dabei können insbesondere die Amplitude bzw. die Feldstärke des Testsignals und die Amplitude bzw. die Feldstärke des Umgebungssignals bei der jeweiligen vorgegebenen Testfrequenz miteinander verglichen werden. Die oben genannten vorgegebenen Referenzwerte können vorgespeicherte Werte sein, die in einer Vorabmessung an einer funktionsfähigen zweiten Antenne vermessen wurden. Diese Referenzwerte können in dem Rundfunk-Empfangssystem beispielweise am Werk vor der Inbetriebnahme des Rundfunk-Empfangssystem in der Steuerung gespeichert sein.

Bei der Diagnose können mehrere Testsignale mit jeweils einer abweichenden Testfrequenz erzeugt und von der Steuerung zur Bewertung der Funktionsfähigkeit der zweiten Antenne herangezogen werden. Mit anderen Worten kann bei der Diagnose ein vorgegebener Frequenzbereich diskret abgetastet werden. Dadurch kann die Funktionalität der zweiten Antenne in dem vorgegebenen Frequenzbereich getestet werden. Analog können bei der Referenzmessung mehrere Umgebungssignale mit jeweils einer abweichenden Testfrequenz erzeugt und von der Steuerung zur Bewertung der Funktionsfähigkeit der zweiten Antenne abgespeichert werden. Die Testsignale und die Umgebungssignale werden dabei jeweils bei derselben Testfrequenz erzeugt. Durch die Steuerung kann die Testfrequenz des Testsignals des lokalen Oszillators des ersten Empfängers frei abgestimmt sein, so dass die Signalstärke des empfangenen Testsignals mit der Signalstärke des Umgebungssignals bei der vordefinierten Testfrequenz verglichen werden kann.

Vor der Diagnose und/oder vor der Referenzmessung kann ein Phasen-Diversität-Modus des Rundfunk-Empfangssystems ausgeschaltet und nach der Diagnose und/oder nach der Referenzmessung eingeschaltet werden. Vor der Diagnose und/oder vor der Referenzmessung können der erste Empfänger und/oder der zweite Empfänger des Rundfunk-Empfangssystems stummgeschaltet und nach der Diagnose und/oder nach der Referenzmessung lautgeschaltet - also das Stummschalten aufgehoben - werden.

Die Erfindung betrifft auch ein Rundfunk-Empfangssystem für ein Kraftfahrzeug. Das Rundfunk-Empfangssystem weist dabei einen ersten Sende-Empfangspfad und einen zweiten Sende-Empfangspfad auf. Der erste Sende-Empfangspfad ist durch einen ersten Empfänger mit einem lokalen Oszillator und eine mit dem ersten Empfänger signalübertragend bzw. elektrisch verbundene erste Antenne und der zweite Sende-Empfangspfad ist durch einen zweiten Empfänger und eine mit dem zweiten Empfänger signalübertragend bzw. elektrisch verbundene zweite Antenne gebildet. Die beiden Antennen sind dabei signalübertragend bzw. elektromagnetisch miteinander koppelbar. Zudem weist das Rundfunk-Empfangssystem eine Steuerung zum Steuern der beiden Sende-Empfangspfade auf. Erfindungsgemäß ist das Rundfunk-Empfangssystem zum Ausführen des oben beschriebenen Diagnoseverfahrens ausgelegt.

Der zweite Sende-Empfangspfad kann einen Signalverstärker aufweisen und der Signalverstärker kann zwischen der zweiten Antenne und dem zweiten Empfänger geschaltet sein. Der Signalverstärker kann insbesondere das von der zweiten Antenne empfangene Testsignal und/oder das von der zweiten Antenne empfangene Umgebungssignal verstärken. Der erste Sende-Empfangspfad kann einen Umleitungspfad mit einem Schalter aufweisen, wobei der Umleitungspfad von dem lokalen Oszillator des ersten Empfängers zu der ersten Antenne führt. Wie oben bereits beschrieben ist, kann der Schalter insbesondere ein HF-Umschalter sein.

Wie oben bereits beschrieben ist, kann die Steuerung des Rundfunk-Empfangssystems durch einen Mikrokontroller abgebildet sein. Die Steuerung kann zweckgemäß signalübertragend bzw. elektrisch mit den Empfängern verbunden sein. Der erste Empfänger kann neben dem lokalen Oszillator auch weitere Bauelemente aufweisen. So kann der erste Empfänger neben dem lokalen Oszillator wenigstens einen Bandpassfilter und/oder wenigstens einen Mischer und/oder wenigstens einen Analog-Digital-Umsetzer und/oder wenigstens einen digitalen Signalprozessor aufweisen. Es versteht sich, dass der zweite Empfänger und der erste Empfänger zueinander identisch aufgebaut sein können. Insbesondere kann der zweite Empfänger gleiche Bauelemente aufweisen.

Um Wiederholungen zu vermeiden, wird bezüglich weiterer Merkmale des Rundfunk-Empfangssystems auf die obige Beschreibung des Diagnoseverfahrens verwiesen.

Die Erfindung betrifft auch ein Kraftfahrzeug mit dem oben beschriebenen Rundfunk-Empfangssystem. Wie oben bereits beschrieben ist, weist das Rundfunk-Empfangssystem die erste Antenne und die zweite Antenne auf. Erfindungsgemäß sind die Antennen des Rundfunk-Empfangssystems Scheibenantennen. Dabei kann das Kraftfahrzeug wenigstens eine Scheibe aufweisen und die erste Antenne und die zweite Antenne in derselben Scheibe verbaut sein. Alternativ kann das Kraftfahrzeug wenigstens zwei physisch voneinander getrennte Scheiben aufweisen und die erste Antenne in der einen Scheibe und die zweite Antenne in der anderen Scheibe verbaut sein.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen.

Dabei zeigen, jeweils schematisch:
- Fig. 1: eine Ansicht eines erfindungsgemäßen Rundfunk-Empfangssystems an einer Scheibe eines Kraftfahrzeugs;
- Fig. 2: ein Ablaufdiagramm zu einem erfindungsgemäßen Diagnoseverfahren an dem erfindungsgemäßen Rundfunk-Empfangssystem.

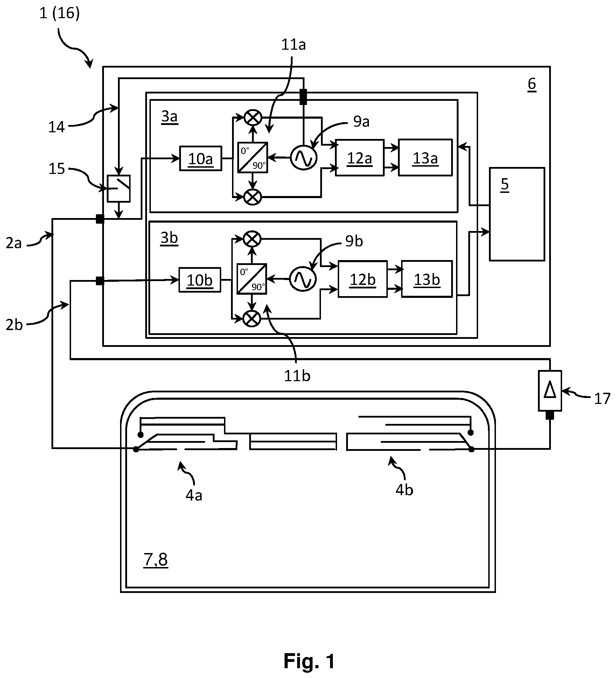

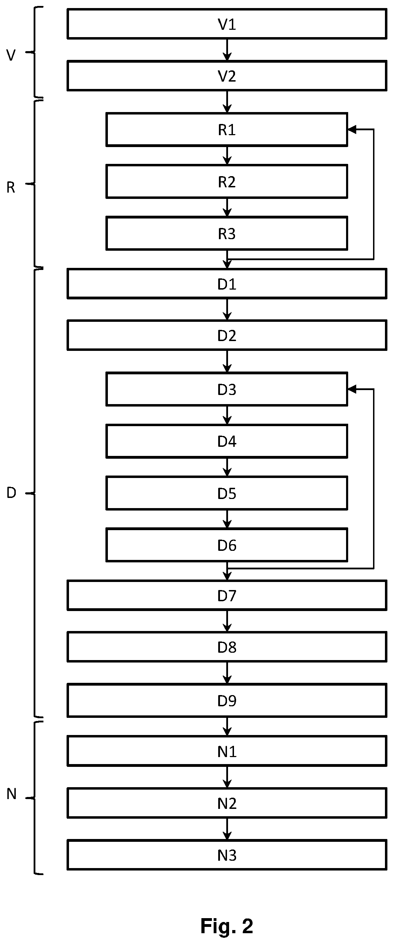

Fig. 1 zeigt eine Ansicht eines erfindungsgemäßen Rundfunk-Empfangssystems 1. Das Rundfunk-Empfangssystem 1 ist zum Ausführen eines erfindungsgemäßen Diagnoseverfahrens 16 ausgelegt. Das Diagnoseverfahrens 16 und die Funktion des Rundfunk-Empfangssystems 1 werden im Folgenden anhand Fig. 2 näher erläutert.

Das Rundfunk-Empfangssystem 1 weist dabei einen ersten Sende-Empfangspfad 2a und einen zweiten Sende-Empfangspfad 2b auf. Das Rundfunk-Empfangssystems 1 umfasst zudem einen ersten Empfänger 3a und eine erste Antenne 4a, die signalübertragend bzw. elektrisch leitend miteinander verbunden sind und den Sende-Empfangspfad 2a abbilden. Zudem umfasst das Rundfunk-Empfangssystems 1 einen zweiten Empfänger 3b und eine zweite Antenne 4b, die signalübertragend bzw. elektrisch leitend miteinander verbunden sind und den Sende-Empfangspfad 2b abbilden. Die erste Antenne 4a und die zweite Antenne 4b sind signalübertragend bzw. elektromagnetisch miteinander koppelbar und sind dazu entsprechend aneinander angeordnet.

Zudem weist das Rundfunk-Empfangssystem 1 eine Steuerung 5 zum Steuern der beiden Sende-Empfangspfade 2a und 2b auf. Die Steuerung 5 und die beiden Empfänger 3a und 3b sind in einer gemeinsamen Baueinheit 6 - einem sogenannten Tuner-IC bzw. einem sogenannten Remote-Tuner-Modul - zusammengefasst.

Die beiden Antennen 4a und 4b sind Scheibenantennen bzw. durch flache Antennenstrukturen abgebildet und sind auf einer gemeinsamen Scheibe 7 eines Kraftfahrzeugs 8 verbaut. Die Scheibe 7 ist dabei kein Teil des erfindungsgemäßen Rundfunk-Empfangssystems 1.

Der jeweilige Empfänger 3a bzw. 3b umfasst jeweils einen lokalen Oszillator 9a bzw. 9b, einen Bandpassfilter 10a bzw. 10b, einen Mischer 11a bzw. 11b, einen Analog-Digital-Umsetzer 12a bzw. 12b und einen digitalen Signalprozessor 13a bzw. 13b. Die beiden Empfänger 3a und 3b sind identisch zueinander aufgebaut. Der jeweilige Empfänger 3a bzw. 3b ist mit der Steuerung 5 über den digitalen Signalprozessor 13a bzw. 13b signalübertragend bzw. elektrisch leitend verbunden.

Der erste Sende-Empfangspfad 2a umfasst zudem einen Umleitungspfad 14 mit einem Schalter 15. Der Umleitungspfad 14 führt dabei von dem lokalen Oszillator 9a des ersten Empfängers 3a zu der ersten Antenne 4a. Der zweite Sende-Empfangspfad 2b umfasst zudem einen Signalverstärker 17, der zwischen der zweiten Antenne 4b und dem zweiten Empfänger 3b angeordnet bzw. geschaltet ist und empfangene Signale der zweiten Antenne (4b) verstärkt.

Fig. 2 zeigt ein Ablaufdiagramm des erfindungsgemäßen Diagnoseverfahrens 16 in dem erfindungsgemäßen Rundfunk-Empfangssystem 1. In dem erfindungsgemäßen Diagnoseverfahren 16 kann die Funktionalität der zweiten Antenne 4b überprüft werden. Dabei werden eine Vorbereitung V mit Teilschritten V1-V2, eine Referenzmessung R mit Teilschritten R1-R3, eine Diagnose D mit Teilschritten D1-D9 und eine Nachbereitung N mit Teilschritten N1-N3 durchgeführt.

Bei der Vorbereitung V wird das Rundfunk-Empfangssystem 1 für weitere Schritte vorbereitet. Dabei wird in dem Teilschritt V1 der zweite Empfänger 3b des Rundfunk-Empfangssystems 1 stummgeschaltet. Danach wird in dem Teilschritt V2 ein Phasen-Diversität-Modus des Rundfunk-Empfangssystems 1 ausgeschaltet.

Da es nicht ausgeschlossen sein kann, dass die zweite Antenne 4b während des Diagnoseverfahrens 16 weitere externe Signale empfängt, wird die Referenzmessung R durchgeführt. Bei der Referenzmessung R werden Umgebungssignale bzw. externe Signale vermessen und bei der Bewertung der Funktionalität der zweiten Antenne 4b berücksichtigt. Dabei wird in dem Teilschritt R1 der zweite Empfänger 3b auf eine vorgegebene erste Testfrequenz eingestellt. Danach wird in dem Teilschritt R2 das Umgebungssignal bei der vorgegebenen ersten Testfrequenz über die zweite Antenne 4b empfangen und in dem Teilschritt R3 das empfangene Umgebungssignal über den zweiten Empfänger 3b zu der Steuerung 5 geleitet und dort gespeichert. Die Teilschritte R1-R3 werden für mehrere voneinander abweichende Testfrequenzen durchgeführt. Mit anderen Worten werden Umgebungssignale in einem vorgegebenen Frequenzbereich aufgenommen und in der Steuerung 5 gespeichert. Dabei können insbesondere die Amplitude bzw. die Feldstärke des empfangenen Umgebungssignals in einer zugeordneten Speicherzelle der jeweiligen vorgegebenen Testfrequenz abgespeichert werden.

Sobald die Referenzmessung R beendet ist, wird die Diagnose D durchgeführt. Bei der Diagnose D wird die zweite Antenne 4b auf die Funktionalität getestet. In dem Teilschritt D1 wird der lokale Oszillator 9a des ersten Empfängers 3a aktiviert und in dem Teilschritt D2 wird der Schalter 15 geschlossen und dadurch der Umleitungspfad 14 aktiviert. In dem Teilschritt D3 wird ein Testsignal mit der vorgegebenen ersten Testfrequenz in dem ersten Sende-Empfangspfad 2a über den lokalen Oszillator 9a erzeugt und von der ersten Antenne 4a ausgesendet. In dem Teilschritt D4 wird der zweite Empfänger 3b auf die vorgegebene erste Testfrequenz eingestellt. Danach wird in dem Teilschritt D5 das von der ersten Antenne 4a gesendete Testsignal bei der vorgegebenen ersten Testfrequenz über die zweite Antenne 4b empfangen und in dem Teilschritt D6 über den zweiten Empfänger 3b zu der Steuerung 5 geleitet und dort gespeichert. Auch hier können die Amplitude bzw. die Feldstärke des empfangenen Testsignals in einer zugeordneten Speicherzelle der jeweiligen vorgegebenen Testfrequenz abgespeichert werden. Die Teilschritte D3-D6 werden dabei für mehrere voneinander abweichende Testfrequenzen durchgeführt. Auch hier wird also ein Frequenzbereich diskret vermessen. Die vorgegebenen Testfrequenzen der erzeugten Testsignale korrelieren mit den bei der Referenzmessung R verwendeten Testfrequenzen, so dass ein Vergleich der Umgebungssignale und der Testsignale möglich ist. In dem Teilschritt D7 wird der Schalter 15 geöffnet und der Umleitungspfad 14 deaktiviert. Danach wird der lokale Oszillator 9a des ersten Empfängers 3a in dem Teilschritt D8 deaktiviert.

In dem Teilschritt D9 erfolgt nun die Bewertung der Funktionsfähigkeit der zweiten Antenne 4b. Dazu werden für die jeweilige vorgegebene Testfrequenz das empfangene Umgebungssignal und das empfangene Testsignal verglichen. Wie oben bereits beschrieben ist, können hier die abgespeicherten Amplituden bzw. die abgespeicherten Feldstärken miteinander verglichen werden. Falls bei den vorgegebenen Testfrequenzen das Testsignal um einen vordefinierten Referenzwert stärker als das Umgebungssignal ist, ist die zweite Antenne 4b funktionsfähig und sonst nicht funktionsfähig. Die vordefinierten Referenzwerte können dabei in der Steuerung 5 abgespeichert sein und beispielweise mittels einer Vormessung an einer weiteren funktionsfähigen Antenne ermittelt sein. Das kann bereits am Werk vor der Inbetriebnahme des Rindfunk-Empfangssystems 1 erfolgen.

Nach der Diagnose D erfolgt nun die Nachbereitung N des Rindfunk-Empfangssystems 1. In dem Teilschritt N1 wird die ursprüngliche Empfangsfrequenz in den Empfänger 3a und 3b eingestellt. In dem Teilschritt N2 wird das Phasen-Diversität-Modus des Rundfunk-Empfangssystems 1 eingeschaltet. Anschließend wird in dem Teilschritt N3 der zweite Empfänger 3b des Rundfunk-Empfangssystems 1 lautgeschaltet bzw. das Stummschalten des zweiten Empfängers 3b aufgehoben.

## Patentansprüche

1. Diagnoseverfahren (16) für ein Rundfunk-Empfangssystem (1) eines Kraftfahrzeugs (8),
- wobei das Rundfunk-Empfangssystem (1) einen ersten Sende-Empfangspfad (2a) mit einem ersten Empfänger (3a) mit einem lokalen Oszillator (9a) und einer mit dem ersten Empfänger (3a) signalübertragend verbundenen ersten Antenne (4a) aufweist,
- wobei das Rundfunk-Empfangssystem (1) einen zweiten Sende-Empfangspfad (2b) mit einem zweiten Empfänger (3b) und einer mit dem zweiten Empfänger (3b) signalübertragend verbundenen zweiten Antenne (4b) aufweist,
- wobei die beiden Antennen (4a, 4b) signalübertragend miteinander koppelbar sind, und
- wobei das Rundfunk-Empfangssystem (1) eine Steuerung (5) zum Steuern der beiden Sende-Empfangspfade (2a, 2b) aufweist,
- wobei in dem Diagnoseverfahren (16) eine Diagnose (D) durchgeführt wird, wobei bei der Diagnose (D):
- in dem ersten Sende-Empfangspfad (2a) ein Testsignal mit einer vorgegebenen Testfrequenz durch den lokalen Oszillator (9a) des ersten Empfängers (3a) erzeugt und über die erste Antenne (4a) ausgesendet wird,
- in dem zweiten Sende-Empfangspfad (2b) das gesendete Testsignal über die zweite Antenne (4b) empfangen und über den zweiten Empfänger (3b) zu der Steuerung (5) geleitet wird, und
- die Steuerung (5) basierend auf dem empfangenen Testsignal die Funktionsfähigkeit der zweiten Antenne (4b) bewertet,
**dadurch gekennzeichnet,**
**dass** in dem Diagnoseverfahren (16) vor der Diagnose (D) eine Referenzmessung (R) durchgeführt wird, wobei bei der Referenzmessung (R):
- in dem ersten Sende-Empfangspfad (2a) der erste Empfänger (3a) ausgeschaltet wird,
- in dem zweiten Sende-Empfangspfad (2b) ein Umgebungssignal bei der vorgegebenen Testfrequenz über die zweite Antenne (4b) empfangen und über den zweiten Empfänger (3b) zu der Steuerung (5) geleitet wird, und
- die Steuerung (5) das empfangene Umgebungssignal zur Bewertung der Funktionsfähigkeit der zweiten Antenne (4b) abspeichert.

2. Diagnoseverfahren (16) nach Anspruch 1,
**dadurch gekennzeichnet, dass**
- das Testsignal von dem lokalen Oszillator (9a) des ersten Empfängers (3a) zu der ersten Antenne (4a) über einen Umleitungspfad (14) mit einem Schalter (15) geleitet wird, und
- dass der Schalter (15) des Umleitungspfads (14) beim Durchführen der Diagnose (D) geschlossen und sonst geöffnet ist.

3. Diagnoseverfahren (16) nach Anspruch 1,
**dadurch gekennzeichnet, dass**
- die Steuerung (5) das empfangene Testsignal und das empfangene externe Signal aus Umgebung bei der jeweiligen vorgegebenen Testfrequenz bewertet, und
- dass die Steuerung (5), sobald bei der jeweiligen vorgegebenen Testfrequenz das Testsignal um einen vordefinierten Referenzwert stärker als das externe Signal aus Umgebung ist, die zweite Antenne (4b) als funktionsfähig und sonst als nicht funktionsfähig bewertet.

4. Diagnoseverfahren (16) nach Anspruch 1,
**dadurch gekennzeichnet, dass**
- bei der Diagnose (D) mehrere Testsignale, wobei jedes Testsignal eine abweichende Testfrequenz aufweist, erzeugt und von der Steuerung (5) zur Bewertung der Funktionsfähigkeit der zweiten Antenne (4b) herangezogen werden, und
- dass bei der Referenzmessung (R) mehrere Umgebungssignale jeweils bei der abweichenden Testfrequenz empfangen und von der Steuerung (5) zur weiteren Bewertung der Funktionsfähigkeit der zweiten Antenne (4b) abgespeichert werden.

5. Diagnoseverfahren (16) nach Anspruch 1,
**dadurch gekennzeichnet, dass**
- vor der Diagnose (D) und/oder vor der Referenzmessung (R) ein Phasen-Diversität-Modus des Rundfunk-Empfangssystems (1) abgeschaltet und nach der Diagnose (D) und/oder nach der Referenzmessung (R) eingeschaltet wird, und/oder
- dass vor der Diagnose (D) und/oder vor der Referenzmessung (R) der erste Empfänger (3a) und/oder der zweite Empfänger (3b) des Rundfunk-Empfangssystems (1) stummgeschaltet und nach der Diagnose (D) und/oder nach der Referenzmessung (R) lautgeschaltet werden.

6. Rundfunk-Empfangssystem (1) für ein Kraftfahrzeug (8),
- wobei das Rundfunk-Empfangssystem (1) einen ersten Sende-Empfangspfad (2a) mit einem ersten Empfänger (3a) mit einem lokalen Oszillator (9a) und einer mit dem ersten Empfänger (3a) signalübertragend verbundenen ersten Antenne (4a) aufweist,
- wobei das Rundfunk-Empfangssystem (1) einen zweiten Sende-Empfangspfad (2b) mit einem zweiten Empfänger (3b) und einer mit dem zweiten Empfänger (3b) signalübertragend verbundenen zweiten Antenne (4b) aufweist,
- wobei die beiden Antennen (4a, 4b) miteinander signalübertragend koppelbar sind, und
- wobei das Rundfunk-Empfangssystem (1) eine Steuerung (5) zum Steuern der beiden Sende-Empfangspfade (2a, 2b) aufweist,
**dadurch gekennzeichnet, dass**
das Rundfunk-Empfangssystem (1) zum Ausführen des Diagnoseverfahrens (16) nach einem der Ansprüche 1 bis 5 ausgelegt ist.

7. Rundfunk-Empfangssystem (1) nach Anspruch 6,
**dadurch gekennzeichnet, dass**
der zweite Sende-Empfangspfad (2a) einen Signalverstärker (17) aufweist und der Signalverstärker (17) zwischen der zweiten Antenne (4b) und dem zweiten Empfänger (3b) geschaltet ist.

8. Rundfunk-Empfangssystem (1) nach Anspruch 6 oder 7,
**dadurch gekennzeichnet, dass**
der erste Sende-Empfangspfad (2a) einen Umleitungspfad (14) mit einem Schalter (15) aufweist und der Umleitungspfad (14) von dem lokalen Oszillator (9a) des ersten Empfängers (3a) zu der ersten Antenne (4a) führt.

9. Kraftfahrzeug (8) mit einem Rundfunk-Empfangssystem (1) nach einem der Ansprüche 6 bis 8,
**dadurch gekennzeichnet, dass**
die erste Antenne (4a) des Rundfunk-Empfangssystems (1) eine Scheibenantenne und die zweite Antenne (4b) des Rundfunk-Empfangssystems (1) eine Scheibenantenne ist,
- wobei das Kraftfahrzeug (8) wenigstens eine Scheibe (7) aufweist und die erste Antenne (4a) und die zweite Antenne (4b) in derselben Scheibe (7) verbaut sind, oder
- wobei das Kraftfahrzeug (8) wenigstens zwei physisch voneinander getrennte Scheiben (7) aufweist und die erste Antenne (4a) in der einen Scheibe (7) und die zweite Antenne (4b) in der anderen Scheibe (7) verbaut sind.

## Claims

1. Diagnostic method (16) for a radio receiving system (1) of a motor vehicle (8),
- the radio receiving system (1) comprising a first transmit/receive path (2a) having a first receiver (3a) which has a local oscillator (9a) and a first antenna (4a) that is connected to the first receiver (3a) for signal transmission,
- the radio receiving system (1) comprising a second transmit/receive path (2b) having a second receiver (3b) and a second antenna (4b) that is connected to the second receiver (3b) for signal transmission,
- it being possible for the two antennas (4a, 4b) to be coupled to one another for signal transmission, and
- the radio receiving system (1) comprising a control unit (5) for controlling the two transmit/receive paths (2a, 2b),
- a diagnosis (D) being carried out in the diagnostic method (16), wherein, during the diagnosis (D):
- in the first transmit/receive path (2a), a test signal having a predetermined test frequency is generated by the local oscillator (9a) of the first receiver (3a) and transmitted via the first antenna (4a),
- in the second transmit/receive path (2b), the transmitted test signal is received via the second antenna (4b) and routed via the second receiver (3b) to the control unit (5), and
- the control unit (5) evaluates the functionality of the second antenna (4b) on the basis of the received test signal,
**characterized in that**
in the diagnostic method (16), a reference measurement (R) is carried out before the diagnosis (D), wherein, during the reference measurement (R):
- in the first transmit/receive path (2a), the first receiver (3a) is switched off,
- in the second transmit/receive path (2b), an ambient signal at the predetermined test frequency is received via the second antenna (4b) and routed via the second receiver (3b) to the control unit (5), and
- the control unit (5) stores the received ambient signal to evaluate the functionality of the second antenna (4b).

2. Diagnostic method (16) according to claim 1,
**characterized in that**
- the test signal is routed from the local oscillator (9a) of the first receiver (3a) to the first antenna (4a) via a rerouting path (14) having a switch (15), and
- **in that** the switch (15) of the rerouting path (14) is closed when the diagnosis (D) is carried out and is otherwise open.

3. Diagnostic method (16) according to claim 1,
**characterized in that**
- the control unit (5) evaluates the received test signal and the received external signal from the environment at the relevant predetermined test frequency, and
- **in that** the control unit (5) evaluates the second antenna (4b) as functional as soon as the test signal is stronger than the external signal from the environment by a predefined reference value at the relevant predetermined test frequency, and otherwise as non-functional.

4. Diagnostic method (16) according to claim 1,
**characterized in that**
- during the diagnosis (D), a plurality of test signals - each test signal having a different test frequency - are generated and used by the control unit (5) to evaluate the functionality of the second antenna (4b), and
- **in that** during the reference measurement (R), a plurality of ambient signals are received at the different test frequency and stored by the control unit (5) for further evaluation of the functionality of the second antenna (4b).

5. Diagnostic method (16) according to claim 1,
**characterized in that**
- a phase diversity mode of the radio receiving system (1) is switched off before the diagnosis (D) and/or before the reference measurement (R) and is switched on after the diagnosis (D) and/or after the reference measurement (R), and/or
- **in that** the first receiver (3a) and/or the second receiver (3b) of the radio receiving system (1) is muted before the diagnosis (D) and/or before the reference measurement (R) and is unmuted after the diagnosis (D) and/or after the reference measurement (R).

6. Radio receiving system (1) for a motor vehicle (8),
- the radio receiving system (1) comprising a first transmit/receive path (2a) having a first receiver (3a) which has a local oscillator (9a) and a first antenna (4a) that is connected to the first receiver (3a) for signal transmission,
- the radio receiving system (1) comprising a second transmit/receive path (2b) having a second receiver (3b) and a second antenna (4b) that is connected to the second receiver (3b) for signal transmission,
- it being possible for the two antennas (4a, 4b) to be coupled to one another for signal transmission, and
- the radio receiving system (1) comprising a control unit (5) for controlling the two transmit/receive paths (2a, 2b),
**characterized in that**
the radio receiving system (1) is designed to perform the diagnostic method (16) according to any of claims 1 to 5.

7. Radio receiving system (1) according to claim 6,
**characterized in that**
the second transmit/receive path (2a) has a signal amplifier (17) and the signal amplifier (17) is connected between the second antenna (4b) and the second receiver (3b).

8. Radio receiving system (1) according to claim 6 or 7,
**characterized in that**
the first transmit/receive path (2a) comprises a rerouting path (14) having a switch (15) and the rerouting path (14) leads from the local oscillator (9a) of the first receiver (3a) to the first antenna (4a).

9. Motor vehicle (8) having a radio receiving system (1) according to any of claims 6 to 8,
**characterized in that**
the first antenna (4a) of the radio receiving system (1) is a disk-type antenna and the second antenna (4b) of the radio receiving system (1) is a disk-type antenna,
- the motor vehicle (8) having at least one window (7) and the first antenna (4a) and the second antenna (4b) being installed in the same window (7), or
- the motor vehicle (8) having at least two physically separate windows (7) and the first antenna (4a) being installed in one window (7) and the second antenna (4b) being installed in the other window (7).

## Revendications

1. Procédé de diagnostic (16) pour un système de réception de radiodiffusion (1) d'un véhicule automobile (8),
- dans lequel le système de réception de radiodiffusion (1) présente un premier trajet d'émission-réception (2a) comportant un premier récepteur (3a) comportant un oscillateur local (9a) et une première antenne (4a) connectée au premier récepteur (3a) de manière à transmettre des signaux,
- dans lequel le système de réception de radiodiffusion (1) présente un second trajet d'émission-réception (2b) comportant un second récepteur (3b) et une seconde antenne (4b) connectée au second récepteur (3b) de manière à transmettre des signaux,
- dans lequel les deux antennes (4a, 4b) peuvent être couplées entre elles de manière à transmettre des signaux, et
- dans lequel le système de réception de radiodiffusion (1) présente une commande (5) pour la commande des deux trajets d'émission-réception (2a, 2b),
- dans lequel un diagnostic (D) est réalisé dans le procédé de diagnostic (16), dans lequel, lors du diagnostic (D) :
- dans le premier trajet d'émission-réception (2a), un signal de test est généré à une fréquence de test prédéfinie par l'oscillateur local (9a) du premier récepteur (3a) et émis par l'intermédiaire de la première antenne (4a),
- dans le second trajet d'émission-réception (2b), le signal de test émis est reçu par l'intermédiaire de la seconde antenne (4b) et acheminé vers la commande (5) par l'intermédiaire du second récepteur (3b), et
- la commande (5) évalue le bon fonctionnement de la seconde antenne (4b) en fonction du signal de test reçu,
**caractérisé en ce**
**que,** dans le procédé de diagnostic (16), une mesure de référence (R) est réalisée avant le diagnostic (D), dans lequel, lors de la mesure de référence (R) :
- dans le premier trajet d'émission-réception (2a), le premier récepteur (3a) est désactivé,
- dans le second trajet d'émission-réception (2b), un signal d'environnement est reçu à la fréquence de test prédéfinie par l'intermédiaire de la seconde antenne (4b) et acheminé vers la commande (5) par l'intermédiaire du second récepteur (3b), et
- la commande (5) enregistre le signal d'environnement reçu afin d'évaluer le bon fonctionnement de la seconde antenne (4b).

2. Procédé de diagnostic (16) selon la revendication 1,
**caractérisé en ce que**
- le signal de test est acheminé depuis l'oscillateur local (9a) du premier récepteur (3a) vers la première antenne (4a) par l'intermédiaire d'un trajet de dérivation (14) comportant un commutateur (15), et
- **que** le commutateur (15) du trajet de dérivation (14) est fermé lors de la réalisation du diagnostic (D) et ouvert le reste du temps.

3. Procédé de diagnostic (16) selon la revendication 1,
**caractérisé en ce que**
- la commande (5) analyse le signal de test reçu et le signal externe reçu provenant de l'environnement à la fréquence de test prédéfinie respective, et
- **que** la commande (5), dès que, à la fréquence de test prédéfinie respective, le signal de test est plus fort que le signal externe provenant de l'environnement d'une valeur de référence prédéfinie, considère la seconde antenne (4b) comme fonctionnelle et, dans le cas contraire, comme non fonctionnelle.

4. Procédé de diagnostic (16) selon la revendication 1,
**caractérisé en ce que**
- lors du diagnostic (D), plusieurs signaux de test sont générés, dans lequel chaque signal de test présente une fréquence de test différente, et sont utilisés par la commande (5) pour évaluer le bon fonctionnement de la seconde antenne (4b), et
- **que,** lors de la mesure de référence (R), plusieurs signaux d'environnement sont reçus respectivement à la fréquence de test différente et enregistrés par la commande (5) pour une autre évaluation du bon fonctionnement de la seconde antenne (4b).

5. Procédé de diagnostic (16) selon la revendication 1,
**caractérisé en ce que**
- avant le diagnostic (D) et/ou avant la mesure de référence (R), un mode de diversité de phase du système de réception de radiodiffusion (1) est désactivé, puis activé après le diagnostic (D) et/ou après la mesure de référence (R), et/ou
- **que**, avant le diagnostic (D) et/ou avant la mesure de référence (R), le premier récepteur (3a) et/ou le second récepteur (3b) du système de réception de radiodiffusion (1) sont commutés vers le mode silencieux et, après le diagnostic (D) et/ou après la mesure de référence (R), sont commutés vers le mode sonore.

6. Système de réception de radiodiffusion (1) pour un véhicule automobile (8),
- dans lequel le système de réception de radiodiffusion (1) présente un premier trajet d'émission-réception (2a) comportant un premier récepteur (3a) comportant un oscillateur local (9a) et une première antenne (4a) connectée au premier récepteur (3a) de manière à transmettre des signaux,
- dans lequel le système de réception de radiodiffusion (1) présente un second trajet d'émission-réception (2b) comportant un second récepteur (3b) et une seconde antenne (4b) connectée au second récepteur (3b) de manière à transmettre des signaux,
- dans lequel les deux antennes (4a, 4b) peuvent être couplées entre elles de manière à transmettre des signaux, et
- dans lequel le système de réception de radiodiffusion (1) présente une commande (5) pour la commande des deux trajets d'émission-réception (2a, 2b),
**caractérisé en ce que**
le système de réception de radiodiffusion (1) est configuré pour exécuter le procédé de diagnostic (16) selon l'une des revendications 1 à 5.

7. Système de réception de radiodiffusion (1) selon la revendication 6,
**caractérisé en ce que**
le second trajet d'émission-réception (2a) présente un amplificateur de signal (17) et l'amplificateur de signal (17) est monté entre la seconde antenne (4b) et le second récepteur (3b).

8. Système de réception de radiodiffusion (1) selon la revendication 6 ou 7,
**caractérisé en ce que**
le premier trajet d'émission-réception (2a) présente un trajet de dérivation (14) comportant un commutateur (15) et le trajet de dérivation (14) mène de l'oscillateur local (9a) du premier récepteur (3a) vers la première antenne (4a).

9. Véhicule automobile (8) comportant un système de réception de radiodiffusion (1) selon l'une des revendications 6 à 8,
**caractérisé en ce que**
la première antenne (4a) du système de réception de radiodiffusion (1) est une antenne de vitre et la seconde antenne (4b) du système de réception de radiodiffusion (1) est une antenne de vitre,
- dans lequel le véhicule automobile (8) présente au moins une vitre (7) et la première antenne (4a) et la seconde antenne (4b) sont intégrées dans ladite vitre (7), ou
- dans lequel le véhicule automobile (8) présente au moins deux vitres (7) séparées physiquement l'une de l'autre et la première antenne (4a) est intégrée dans l'une des vitres (7) et la seconde antenne (4b) est intégrée dans l'autre vitre (7).
